(19) Europäisches Patentamt
European Patent Office
Office européen des brevets

(11) **EP 1 942 350 A1**

(12) **EUROPEAN PATENT APPLICATION**

(43) Date of publication:
**09.07.2008 Bulletin 2008/28**

(51) Int Cl.:
***G01R 33/565*** $^{(2006.01)}$

(21) Application number: **08003252.7**

(22) Date of filing: **02.04.2004**

(84) Designated Contracting States:
**AT BE BG CH CY CZ DE DK EE ES FI FR GB GR HU IE IT LI LU MC NL PL PT RO SE SI SK TR**

(30) Priority: **04.04.2003 GB 0307883**

(62) Document number(s) of the earlier application(s) in accordance with Art. 76 EPC:
**04725426.3 / 1 611 453**

(71) Applicants:
• **THE INSTITUTE OF CANCER RESEARCH: ROYAL CANCER HOSPITAL**
  **London SW7 3RP (GB)**
• **THE ROYAL MARSDEN NHS FOUNDATION TRUST**
  **Sutton,**
  **Surrey SM2 5PT (GB)**

(72) Inventors:
• **Leach, Martin Osmund**
  **West Sussex**
  **RH19 3RX (GB)**
• **Reinsberg, Stefan Alexander**
  **Surrey**
  **KT18 7SW (GB)**
• **Moore, Elizabeth May**
  **Penge**
  **SE20 8QU (GB)**

(74) Representative: **Fearnside, Andrew Simon**
  **Mewburn Ellis LLP**
  **York House**
  **23 Kingsway**
  **GB-London WC2B 6HP (GB)**

Remarks:
This application was filed on 22.02.2008 as a divisional application to the application mentioned under INID code 62.

(54) **CORRECTION OF GEOMETRIC DISTORTIONS IN MAGNETIC RESONANCE IMAGES**

(57) A method and apparatus to concurrently acquire two sets of image data during the same image data acquisition interval in which the magnetic field (2) associated with acquisition of the first data set is caused to differ from the magnetic field (3) associated with acquisition of the second data set. A repeated change of the magnetic field in a pre-determined manner is done during the continuous acquisition of image data comprising the two sets. The relationship between the differing magnetic fields, most preferably the relationship between differing gradient fields, may then be employed in conjunction with the first and second data sets to correct image distortions arising in images constructed according to the data in either set alone.

FIG. 1

**Description**

The present invention relates to methods and apparatus for the acquisition of image data and particularly, though not exclusively, for the acquisition of image data for the reconstruction of Magnetic Resonance Imaging (MRI) images representing an imaged object or article. The present invention also relates to methods and apparatus for the processing of image data so acquired for the purposes of image reconstruction.

Nuclear Magnetic Resonance Imaging (MRI) enables internal portions of a human or animal body to be imaged non-invasively. The phenomenon of Nuclear Magnetic Resonance (NMR) occurs when a magnetic field **B** is applied to an object to be imaged. In the presence of the applied magnetic field **B,** the intrinsic nuclear spin of atomic nuclei of the material of the object are caused to precess around the direction of the magnetic field **B.**

The frequency of nuclear spin precession is known as the Larmor frequency ($\omega$) and is given by $\omega = \gamma B$ where the constant of proportionality ($\gamma$) is the gyromagnetic ratio of the nucleus and is distinctive of each atomic nucleus type. Because those nuclear spins aligned with components of spin parallel to the direction of the magnetic field **B** reside in a lower energy state than those nuclei aligned with components of spin antiparallel to **B,** the result is that marginally more nuclei will align in a direction parallel to that of **B.** Thus, the nuclei of the material of the object become partially spin polarised and therefore the material exhibits a net spin density per unit volume, $\rho(x,y,z)$, pointing in the direction of the magnetic field **B**.

However, the Larmor frequency (w)of a given nucleus is typically shifted from the expected value $\omega = \gamma B$ due to the influence of the electron cloud of the atom or molecule within which the precessing nucleus resides. The effect of the electron cloud is to partially shield the precessing nucleus from the applied magnetic field **B.** This results in a shift in the observed Larmor frequency ($\omega$), which shift is substantially proportional to the magnetic field **B** and can be used to identify the atom or molecule within which the nucleus resides. Consequently, the Larmor frequencies of nuclei within an image object can be used to identify and map the variations in molecular and chemical structures within the object, and these internal structures may then be imaged.

These properties are applied in NMR imaging (MRI) by causing the nuclei of the material of an imaged object to precess about an applied magnetic field **B.** This precession is detected, at various parts of the imaged object, as a varying magnetic field signal which oscillates at the shifted Larmor frequency ($\omega$) of the portion of the object being imaged.

Additional magnetic fields known as "gradient fields" are then applied to the imaged object. The gradient fields vary linearly in the x, y and z directions of space and cause the precession frequency of the imaged object to vary from its already shifted Larmor frequency ($\omega$) as a function of the position of a precessing nucleus within the object. It can be shown that, if we denote the derivatives of the gradient fields in the x, y and z directions as $G_x$, $G_y$ and $G_z$ respectively, then the signal received by the NMR device will be given by:

$$Signal(t) = \iiint \rho(x,y,z) \cdot \exp[i\gamma(B + G_x x + G_y y + G_z z)t]dxdydz = e^{i\omega t} S(t) \qquad \text{Eq.1}$$

However, by changing variables such that: $k_x = \gamma G_x t$; $k_y = \gamma G_y t$; and $k_z = \gamma G_z t$: it becomes apparent that the signal S received by the NMR device is simply given by the Fourier transform of the net spin density per unit volume of the nuclei of the object being imaged, as follows:

$$S(k) = \iiint \rho(x,y,z) \cdot \exp[i(k_x x + k_y y + k_z z)]dxdydz \qquad \text{Eq.2}$$

Where $k = (k_x, k_y, k_z)$ is the spatial frequency vector of the spin density function in Fourier-Space (also known as "k-space").

Existing imaging techniques typically require an imaged object to be unvarying during or between successive image acquisition sequences, and this is often impossible to achieve in practice.

This drawback is often especially problematic when attempting to correct image distortions arising in MRI images due to distortions in the magnetic field of an NMR device. Such images typically suffer geometric distortion due to several factors, such as inhomogeneities in the static field **B** and the susceptibility of the imaged object to magnetization. Such distortions arise as a consequence of the position of a proton in the imaged object being derived from its frequency of precession which is in turn determined according to the magnetic field in which it resides. When magnetic gradient fields are applied in conjunction with the static field, a relationship between the magnetic field and the position of the precessing proton can be determined. However, if undesired inhomogeneities occur in the static magnetic field in the proximity of the precessing proton, the result will be a corresponding distortion or error in the measured position thereof, which manifests itself as a geometrical image distortion.

As has been discussed in "A Technique for Accurate Magnetic Resonance Imaging in the Presence of Field Inhomogeneities", Hsuan Chang and J. Michael Fitzpatrick: IEEE Transactions on Medical Imaging, Vol. 11, No. 3, p. 319 (September 1992), the size of the error in measured position depends upon the ratio of the magnetic field inhomogeneity and the magnitude of the gradient field at that position.

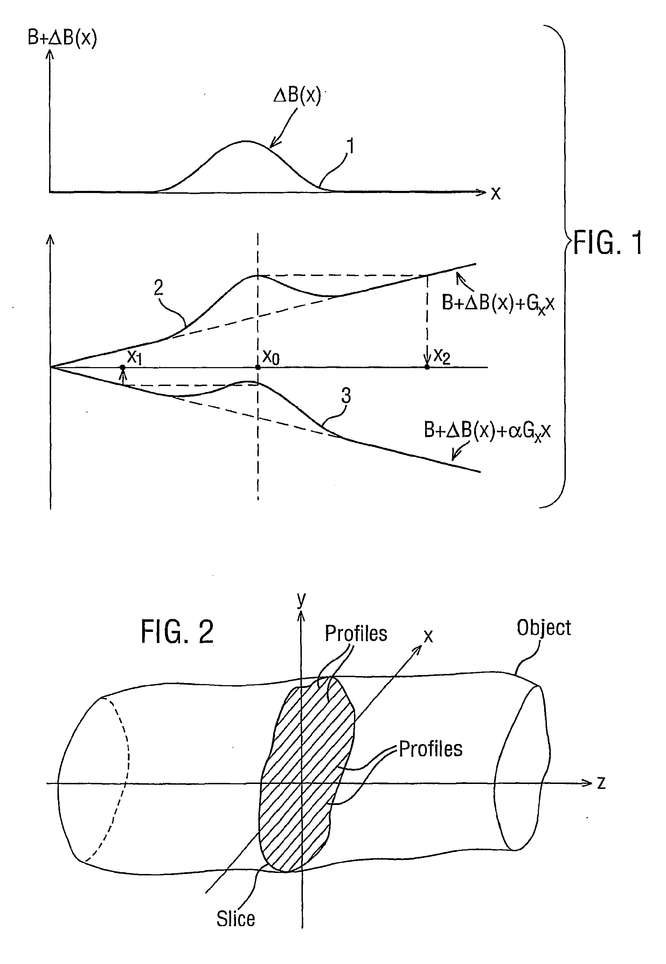

Referring to figure 1 there is illustrated a graphical representation of a magnetic field 1 along a spatial direction (i.e. the x-direction) including a static magnetic field $\mathbf{B}$ component and an inhomogeneity of size $\Delta\mathbf{B}$. Also illustrated is a first modification 2 of this magnetic field arising from the addition of a gradient field $G_x$ in the x-direction, resulting in a magnetic field of $\mathbf{B} + \Delta\mathbf{B} + G_x x$, and a second modification 3 arising from the addition of a different gradient field $\alpha G_x$ of opposite sign resulting in the field $\mathbf{B} + \Delta\mathbf{B} + \alpha G_x x$. A measured position $x_0$ derived from the magnetic field $\mathbf{B} + G_x x$ (in the absence of the inhomogeneity $\Delta\mathbf{B}$) is seen to shift to position $x_1$ by an amount: $x_1 - x_0 = \Delta\mathbf{B}/G_x$ in the presence of the inhomogeneity $\Delta\mathbf{B}$, while the same position $x_0$ derived from the magnetic field $\mathbf{B} + \alpha G_x x$ in the absence of the inhomogeneity $\Delta\mathbf{B}$ is seen to shift to position $x_2$ by an amount: $x_2 - x_0 = \Delta\mathbf{B}/\alpha G_x$ in the presence of the inhomogeneity $\Delta\mathbf{B}$. Solving these two position equations for the correct position $x_0$ is possible independently of the value of the inhomogeneity $\Delta\mathbf{B}$ and requires only the two known erroneous positions ($x_1$ and $x_2$) and the ratio ($\alpha$) of the two gradient fields applied. This allows a correction of image distortions arising from the magnetic field inhomogeneity independently of information regarding the size or nature of that inhomogeneity.

Present techniques implement such correction by acquiring two separate and consecutive images of an object using a fixed gradient field during acquisition of the first image, and a different fixed gradient field during acquisition of the second image.

Unfortunately, NMR imaging (MRI) methods typically have image data acquisition procedures insufficiently rapid to enable a series of images to be taken in rapid succession. The consequence is that movement of an imaged object (or changes within the object) over the period of time between successive image acquisition sequences of the object mean that the two resulting successive images are different not only because of magnetic field distortions but also because of changes in the imaged object itself. Thus, application of the above technique for correcting image distortions due to magnetic field inhomogeneities may fail, or be degraded, when applied to images acquired using existing acquisition methods since the two acquired images may well not be of the same view of the object (the subject may have moved or changed in between or during the two separate image acquisition intervals).

The present invention aims to overcome at least some of the deficiencies inherent in existing image acquisition and processing techniques so as to provide efficient image data acquisition which is less susceptible to movement of, or changes, within the imaged object when acquiring a pair of images of the object. The invention also aims to provide improved processing of such images prior to distortion correction thereof thereby to enhance the corrective effect of, or render more efficient the application of, the aforementioned distortion correction methods and the like. It is to be noted that distortions in an acquired image arising from the magnetic field of the NMR device may be at least partially corrected without recourse to any pre-defined information concerning the distorting effects of that magnetic field according to the present invention.

At its most general the invention proposed is to concurrently acquire two sets of image data during the same image data acquisition interval in which the magnetic field associated with acquisition of the first data set is caused to differ from the magnetic field associated with acquisition of the second data set. The invention proposes to repeatedly change the magnetic field in a pre-determined manner during the continuous acquisition of image data comprising the two sets. The relationship between the differing magnetic fields, most preferably the relationship between differing gradient fields, may then be employed in conjunction with the first and second data sets to correct image distortions arising in images constructed according to the data in either set alone.

Accordingly, in a first of its aspects, the present invention may provide a method of acquiring and processing Magnetic Resonance Image (MRI) data from Nuclear Magnetic Resonance signals generated by an object within a magnetic field having a predetermined spatial gradient, for use in reconstructing an image representing said object, the method comprising the steps of:

acquiring a first set of first image data items using a first value of said predetermined spatial gradient for use in constructing a first image of said object;
acquiring a second set of second image data items using a second value of said predetermined spatial gradient which differs from said first value thereof for use in constructing a second image of said object wherein second image data items of said second set are acquired before acquisition of said first set is complete;
generating third image data items according to first image data items, second image data items and the ratio of said different first and second values of said predetermined spatial gradient.

In another of its aspects of the present invention may omit the step of generating third image data items according to the first image data items, the second image data items and the ratio of said different values of said predetermined spatial gradient. The predetermined spatial gradient is preferably a gradient field G applied by the NMR device, and is most preferably the gradient field corresponding with the scan/read direction of the NMR device, such as a gradient field $G_x$ in the x-coordinate of the NMR device along the scan direction thereof.

Thus, the first set of first image data items and at least some of (preferably all of) the second image data items of the second set are acquired during the same single image data acquisition step or time interval required for complete acquisition of the first set, rather than during separate or discontinuous acquisition intervals. By acquiring image data for two different gradient field values during the same image acquisition sequence, one obviates the need to conduct two completely separate and consecutive image acquisition steps/intervals , i.e. one for each complete set. As a result, one reduces or avoids the problems that arise when the imaged object moves or changes between separate consecutive such intervals. The first image data items and the second image data items may be stored separately upon acquisition thereby resulting in two distinct image data sets each one of which is associated with one of the two different values of the magnetic field gradient of the magnetic field of the NMR device. These distinct image data sets may be subsequently processed separately or together as required.

The second image data items of said second set acquired before acquisition of said first set is complete are preferably acquired from points in Fourier-Space (k-space) which coincide with those points in Fourier-Space from which first image data items of said first set are acquired.

Thus, prior to complete acquisition of the first set, at least some (preferably all) of the second image data items of the second set are acquired from the same Fourier-Space points as those from which at least some (preferably all) of the first image data items of the first set are acquired. Of course, if desired, some of the second image data items may also be acquired from regions/points of Fourier-Space from which none of the first image data items are acquired.

Preferably, the method of acquiring the first set of first image data items and the second set of second image data items includes the steps of:

> (a) acquiring first image data items from a selected set of points in Fourier-Space; and
> (b) acquiring second image data items from said selected set of points in Fourier-Space; and
> (c) selecting a new set of points in Fourier-Space and repeating steps (a) and (b) in respect of said new selected set of points until acquisition of said first set is complete. In this way, first and second image data items are alternately acquired from the same given selected set of Fourier-Space coordinates before a new set of points is selected and the process repeated using the new set until first set of image data items is fully acquired at least.

It is to be noted that step (a) could be performed before step (b), or vice versa, provided that both steps (a) and (b) are performed before each successive step (c) is performed. For example, the sequence of steps could be:

> (A) (a) (b) (c); (a) (b) (c); (a) (b) (c)... etc; or it could be:

> (B) (a) (b) (c); (b) (a) (c); (a) (b) (c)... etc.

Since steps (a) and (b) require different values of the predetermined spatial gradient of the magnetic field, this means that that value must be changed when progressing from step (a) to step (b), or vice versa. Sequence (A) also requires such a value change after each step (c) whereas sequence (B) does not.

The selected set of points in step (a) and (c) may be distributed through Fourier-Space in any chosen manner. A selected set of points may form a line of points in Fourier-Space (which could be part of a larger given scan line), or several such lines, or a curve (e.g. spiral) or several separate curves, or may cover one or more selected areas/regions of Fourier-Space each being of any desired shape and location.

The selected set of points in steps (a) and (c) may each form a respective line of points in Fourier-Space wherein a set of points selected in step (c) may form a line of points being substantially parallel to a line of points formed by the selected set of points employed in preceding steps (a) and (b). In this way, first and second image data items may be acquired alternately, line by line, from each one of a series of parallel lines in Fourier Space. The selected lines are preferably side-by-side and thus the image data acquisition is substantially a raster type scan of Fourier Space.

Each of said parallel lines may extend in only one dimension of Fourier-space. Most preferably, this dimension corresponds with the read-direction or scan-direction of the NMR apparatus along which the device scans the imaged object during image data acquisition.

The third image data items are generated independently of information of image distortions arising from said magnetic field, such that an image of said object generated from said third image data items has less image distortion arising from said magnetic field than is present in an image of said object generated from either the first or the second image data items alone (i.e. the "first image" and "second image" respectively). Thus, once the first and second image data are acquired, corrections of image distortions arising from the magnetic field may follow. The third image data items may be generated to correct both image pixel position errors such as apparent displacement of an image feature within an image frame, and pixel value (magnitude or intensity) errors such as apparent changes in contrast or the like of given image features, as between the first and second images.

Such corrections are preferably generated after an initial processing of first and second image data items which, as discussed in more detail below, enhances the corrective effect of the third image data items.

The third image data items preferably include pixel values of an image representing said object and some or all are generated such that the position ($x_3$) of an image pixel in an image constructed according to the third data items is related to the positions ($x_1$ and $x_2$) of an image pixel in an image constructed according to the first and second data items respectively via the equation:

$$x_3 = \frac{\alpha x_1 - x_2}{\alpha - 1}$$

where $\alpha$ is the value of said ratio of said different values of said predetermined spatial gradient.

Most preferably, the pixel intensity values ($i_3$) of an image pixel at position $x_3$ in an image constructed according to the third data items is related to the pixel intensity values ($i_1$ and $i_2$) of an image pixel in an image constructed according to the first and second data items respectively at positions $x_1$ and $x_2$ via the equation:

$$i_3 = (1 - \alpha) \frac{i_1 \cdot i_2}{i_1 - \alpha \cdot i_2} \ .$$

Thus, the third image data items may be generated using only the first and second image data items and the ratio $\alpha$, but independently of information of image distortions arising from said magnetic field.

The value of the ratio $\alpha$ of said different values of said predetermined spatial gradient is preferably a constant value which may be positive (other than +1) but is preferably negative. The value of $\alpha$ is preferably -1 (minus one) such that image acquisition requires only reversal of the sign of the predetermined gradient field and does not require a change in its magnitude as between acquisition of first and second image data items.

As discussed previously, pixel positions of the third image data items may be determined from the pixel positions of corresponding pixels (i.e. pixels corresponding to the same object feature) in the images generated according to he first and the second image data items. An initial processing of first and second image data items typically enhances the corrective effect of third image data items subsequently generated therefrom if one is able to accurately ascertain which pixels of the first and second images are corresponding pixels. This may be achieved by generating a "map" between corresponding pixels of the first image and second image which explicitly maps each pixel of the first image to its corresponding pixel in the second image.

However, an initial processing step is preferably that of identifying and delineating the feature of interest in both the first and the second images. Since such a feature may well be shifted as between first and second images, so too will the boundary/edge of that feature within the image frame of the first image relative to the image frame of the second image. Thus, a third boundary is preferably derived according to the present invention in accordance with: the boundary of the feature of interest within the first image relative to the image frame thereof; and, the boundary of the feature of interest within the second image relative to the image frame thereof; such that the third boundary delineates the feature of interest when applied to the second image.

The invention, in another aspect or in its first aspect, may include the steps of:

generating first real-space image data items (e.g. pixels) from first image data items, and second real-space image data items (e.g. pixels) from second image data items;
defining (using said first real-space image data items) a first image boundary corresponding to the periphery of a feature within the image frame of an image constructed according to said first real-space image data items;
defining (using said second real-space image data items) a second image boundary corresponding to the periphery of said feature within the image frame of an image constructed according to said second real-space image data items;
defining a third image boundary according to said first boundary and said second boundary;
segmenting said first real-space image data items according to said first image boundary; and,
segmenting said second real-space image data items according to said third image boundary.

In this way a feature of interest within the image frame of both images may be delineated or segmented from the rest of the image data within both images using a suitable image boundary determined from the first and second image data items. Since corresponding image features within the first and second images will typically shift to some degree due to the differing magnetic field gradients employed during image data acquisition, the corresponding boundaries of the feature(s) of interest within the two images will also shift. The third image boundary thus defines a third boundary which better resembles the first image boundary than does the second image boundary, but is shifted by a similar amount as the second image boundary relative to the first image boundary. Use of boundaries simplifies subsequent analysis of the first and second images.

The first and the second real-space image data items are preferably each segmented such that: data items outside said first and third image boundary respectively are discarded; and, data items inside the first and third image boundary respectively are retained. This removes noise or irrelevant data from both the first and second image the presence of which can otherwise seriously hamper subsequent image processing of the features of interest within the images.

Preferably, the third image boundary is defined according to an average of the difference between the first image boundary and the second image boundary. This provides a smoothing of the third boundary.

For example, the third image boundary may be defined by one of the first image boundary and the second image boundary modified according to an average of the difference between the first image boundary and the second image boundary. The first image boundary may be defined by a first image boundary vector and the second image boundary may be defined by a second image boundary vector and said difference between said first image boundary and said second image boundary may be a difference vector being the difference between said first image boundary vector and said second image boundary vector.

Each such vector being a vector preferably defined in image coordinates, such as pixel locations, which are common to both the first and the second image.

Preferably, the third image boundary is defined by a third image boundary vector being either first image boundary vector or the second image boundary vector to which is added an averaged-difference vector being an average of said difference vector. The value of each element of said averaged-difference vector is preferably determined as a weighted average of the values of:

   a corresponding element of said difference vector; and,
   a predetermined number of elements of said difference vector which neighbour said corresponding element.

For example, given a first image boundary vector $\vec{f}$, and a second image boundary vector $\vec{r}$, the difference vector is $\vec{d} = \vec{f} - \vec{r}$. The averaged-difference vector may be a weighted average wherein the $j^{th}$ element of the averaged-difference vector is a weighted average of n elements neighbouring the $j^{th}$ element such as:

$$\vec{d}_j = \frac{1}{n}\sum_{i=0}^{n} w_i \vec{d}_{j-n/2+i}$$

Where the weights $w_i$ may be any suitable values including all $w_i = 1$ (one), in which case the average would be a "Boxcar average" as is well known in the art.

Since features of the first image will be shifted to some degree relative to corresponding features of the second image, it is typically the case that corresponding features will not be located at identical image pixel positions. Thus, given a third image boundary, the present invention may include the steps of identifying features of the second image within the third image boundary which correspond with features of the first image within the first image boundary.

An initial processing of first and second image data items prior to generation of third image data items may preferably be performed as follows so as to map pixels of the first image to corresponding pixels of the second image as discussed above. The following methods of map generation are performed preferably only in respect of pixels within the aforementioned third image boundary. A mapping vector $\vec{m}$ is derived such that the position $x_1$ in the first image corresponds to the pixel $x_2$ in the second image via the relation $m_{x1} := x_2$.

Generation of a map is performed by finding similar features between two compared parts of the first and second images (e.g. two compared scan profiles). The present invention proposes an iterative procedure in which:

   Initially a mapping vector is created which maps every pixel in the first image on to the same position in the second image: $m_i = i$;
   A measure of similarity as between the second image and the mapped first image is then generated;
   Small (e.g. random) changes are made to the mapping vector (e.g. $m'_i = m_i + 1$ for all i within a certain range) and a new measure of similarity as between the second image and the newly mapped first image is then generated; If this new measure represents an improvement over the previously found measure then the old mapping vector is replaced by the new mapping vector, else it is rejected, and the process repeats until no further improvements can be made.

Accordingly, the invention in a further aspect or in its first aspect may include the steps of:

generating first real-space image data items (e.g. pixels) from first image data items, and second real-space image data items (e.g. pixels) from second image data items;

(a) comparing first real-space data items with second real-space data items;
(b) estimating whether or not data items so compared correspond with the same feature of the imaged object; and if not,
(c) iteratively repeating steps (a) and (b) in respect of real-space data items at least one of which differs from any of those compared in the previous iteration of step (a).

This comparison may be performed collectively in respect of groups of first and second image pixels in which different groups of first and/of second image pixels are iteratively compared so as to identify common image features of varying size and/or location. The groups of the first and/or second image pixels are preferably one or more lines of pixels within a respective image. Comparison may thus be done scan-line by scan-line for example.

The invention, in its first aspect, may comprise the steps of:

generating first real-space image data items from said first image data items, and second real-space image data items from said second image data items;

(i) selecting a first set of data items from said first real-space image data items;
(ii) selecting a second set of data items from said second real-space image data items;
(iii) comparing data items from said first set with data items from said second set;
(iv) defining a measure of similarity between data items so compared;
(v) estimating according to said measure of similarity whether or not said real-space data items so compared correspond with the same feature of the imaged object; and if not,
(vi) iteratively repeating steps (ii) to (v) in which at least one data item of said first set is compared to a data item of said second set with which it was not compared in the previous iteration of step (iii).

Accordingly, each of the first and second sets of data items in which the pixels of the first group are mapped onto pixels of the second group, but the nature of the map is iteratively varied to find the optimal map.

Preferably, the compared sets of data items represent selected areas of a respective image containing a feature of interest for comparison.

Accordingly, the first set and said second set of data items comprises image pixel values corresponding to a group of pixels positioned within an image constructed according to said first and said second real-space image data items respectively whereby the pixel position of each element of the group neighbours the pixel position of another element of the group.

The map generation procedure may include collectively shifting only some pixel positions within a group of pixels upon successive iterations. This may occur when it appears that some of the pixels within the group (e.g. a sub area of pixels) have been adequately mapped, but others (e.g. another sub area of pixels) have not. These others may be separately shifted iteratively (i.e. the mapping vector changed only in respect of those pixel positions) in order to obtain an improved overall mapping vector.

Accordingly, step (ii) of the above map generation procedure preferably includes selecting a subset of one or more data items from within said second set defining a subgroup of pixel values whereby the pixel position of each element of the subgroup neighbours the pixel position of another element of the subgroup when the subgroup comprises a plurality of elements, and in which step (iii) includes comparing pixel values of the first set with pixel values of the second set in which the pixel position of at least one element of said subset is displaced relative to the pixel position of the same element during the previous iteration of step (iii).

This may also occur simply to determine which parts of the mapping vector are most in need of modification. That is to say, by iteratively changing different parts of the mapping vector one can assess many different maps and determine, according to said measure of similarity associated with each such different mapping vector, how best to modify the mapping vector.

When the estimation according to step (v) is affirmative steps (ii) to (v) and (vi) are performed in respect only of elements within the subset in respect of which the affirmative estimation according to step (v) was obtained.

For example, each successive subset may comprise a predetermined proportion of the total number of elements of the previous subset (or set) from which they are selected.

For example, the predetermined proportion is one half such that map generation would initially shift one half of the initially estimated mapping vector. The selected half could be shifted in one mapping direction, then in the opposite mapping direction, and a comparison of the measures of similarity obtained in respect of each such shifted mapping vector could then be made. The shifted mapping vector having a better measure of similarity could be further processed by selecting a subset of one half of the elements from within the previously selected half (i.e. one quarter selected) and repeating the shifting and similarity-comparing steps above until no further halving can occur.

The measure of similarity may be a measure of correlation between a first set or group of pixels from the first image and a second group or set of pixels from the second image to which the first set is mapped via the mapping vector. For example, given a mapping vector $\vec{m}$, the correlation may be defined according to the pixel values of the first set of pixels $\vec{i}_1$, and the pixel values of the second set of pixels $\vec{i}_2(\vec{m})$ chosen according to the mapping vector, as:

$$\text{Similarity Measure} = corr(\vec{i}_1, \vec{i}_2(\vec{m}))$$

The larger the value of this measure, the greater the degree of similarity. Alternatively, the similarity measure may be a measure of the "Mutual Information" (MI) contained within the first set and the second set of data according to the mapping vector. This is achieved by obtaining a transformation $\vec{m}$ which maps the first image to the second mage such the information contained in both, at the same time, is maximal. The measure of similarity may be defined in terms of the entropy $H(\vec{i}_1)$ contained in the first set (or subset) of pixel values, and the entropy $H(\vec{i}_2(\vec{m}))$ contained in the second set (or subset) of pixel values after applying the mapping. Preferably, the measure of similarity is defined as:

$$\text{Similarity Measure} = H(\vec{i}_1) + H(\vec{i}_2(\vec{m})) - H(\vec{i}_1, \vec{i}_2(\vec{m}))$$

where the third term defines the joint entropy of the first and second sets. Definitions of entropy may be employed such as would be readily apparent to the skilled person.

Preferably, the measure of similarity is determined in respect of a given first set of pixels - such as a line/profile of pixels in the first image - relative to a plurality (e.g. three, five or more) of neighbouring second sets of pixels - such as a plurality of neighbouring lines or profiles in the second image. This helps to stabilize the map generation algorithm due to the averaging of noise.

The map generation algorithm may modify the mapping iteratively by exhaustively searching all possible maps similar to, or in the proximity of, the given current map. Alternatively, the modification may be random, psuedo-random or directed in the direction of improving similarity measure. In the latter directed variant an optimisation algorithm may be employed to optimise the similarity measure during said mapping modifications. Any suitable optimisation algorithm may be employed such as would be readily apparent to the skilled person e.g. using a Newton-Raphson optimisation algorithm or the like.

The present invention may provide a method of constructing nuclear Magnetic Resonance images (MRI) or other images using the method of the invention in any aforementioned aspect.

The invention may provide apparatus for constructing nuclear Magnetic Resonance Imaging (MRI) images according to the invention in its first aspect, and including none, some or all of the preferably features, alternative features and modified steps discussed above.

Accordingly, in a second of its aspects, the present invention may provide apparatus for acquiring and processing Magnetic Resonance Image data as defined in Paragraph 24 below. The invention in its second aspect may be provided with the additional features according to any one or more of Paragraphs 25 to 46 below.

In a third of its aspects, the present invention may provide a computer system for use according to the method of the present invention in its first aspect including none, some or all variants/ modifications discussed above.

The present invention may also provide for the use of a computer system according to the method of the present invention in its first aspect.

In a fourth of its aspects, the present invention may provide a program for a computer comprising computer code which when executed on a computer system implements a method according to the invention in its first aspect including none, some or all of the variants or modifications thereto discussed above using acquired image data.

The invention may provide a computer program product storing a program for a computer according the fourth aspect of the invention.

The present invention may provide an image generated according to, or using, and of the methods or apparatus of the present invention in any of its aspects.

Non-limiting examples of the present invention follow in the embodiments described below with reference to the accompanying drawings in which:

Figure 1 schematically illustrates an example of image pixel position errors arising from distortions in the magnetic field of an NMR device;

Figure 2 schematically illustrates an imaged slice of an object in the coordinate system of an NMR device during the acquisition of image data for Magnetic Resonance Imaging (MRI);

Figure 3 schematically illustrates alternate acquisition of first and second image data items from selected lines in Fourier-space;

Figure 4 schematically represents a first image and a second image shifted relative to the first within a common image frame;

Figures 5a and 5b schematically illustrate shifted boundaries of a common image feature within a first and second image respectively;

Figure 6a illustrates the position of the boundaries illustrated in figures 5a and 5b as a function of pixel line number;

Figure 6b illustrates the difference in boundary positions illustrated in figure 6a as a function of pixel line number;

Figure 7 illustrates a map between two profiles.

Figure 2 illustrates schematically an imaged object within the coordinate system of an NMR imaging device. The object is bathed in a magnetic field comprising a static component B aligned along the z-axis and gradient fields with gradients $G_{x\_}$, $G_y$, and $G_z$ in the x, y and z-directions respectively.

The object is imaged in slices lying within the x-y plane of the coordinate system, each image slice comprising a raster array of neighbouring image lines ("profiles") each formed from a line of image pixels in the x-direction and collectively forming a two-dimensional array of image pixels forming a two-dimensional image of the imaged slice. Three-dimensional images (volumes) may be constructed from a plurality of neighbouring 2-dimensional image slices.

The imaged object may be sliced at any orientation. This is achieved by using a suitable combination of all three gradients Gx, Gy, and Gz. The xyz system refers to a reference of frame that is fixed with respect to the magnet/ scanner of the NMR system. The user/operator of the system may choose to image along a plane at arbitrary rotation to the xyz planes and achieves this by using a linear combination of non-zero gradient fields, e.g. equal strength of Gx and Gy results in an imaging plane as drawn in Fig. 2 but with profiles running diagonally. In such cases a second "RPS" coordinate system is defined by: the read direction (R); the phase encode direction (P); and, the slice select direction (S) (2D alias multislice acquisition) or 'second' phase encode direction (3D acquisition). It is to be understood that the invention in any of its aspects may be implemented using any suitable coordinate system (such as the "RPS" system) as would be readily apparent to the skilled person.

However, in the following non-limiting embodiments for the purposes if illustrative simplicity, an un-rotated xyz coordinate system is used in which the aforesaid predetermined gradient field is applied along the x-dimension of the coordinate system.

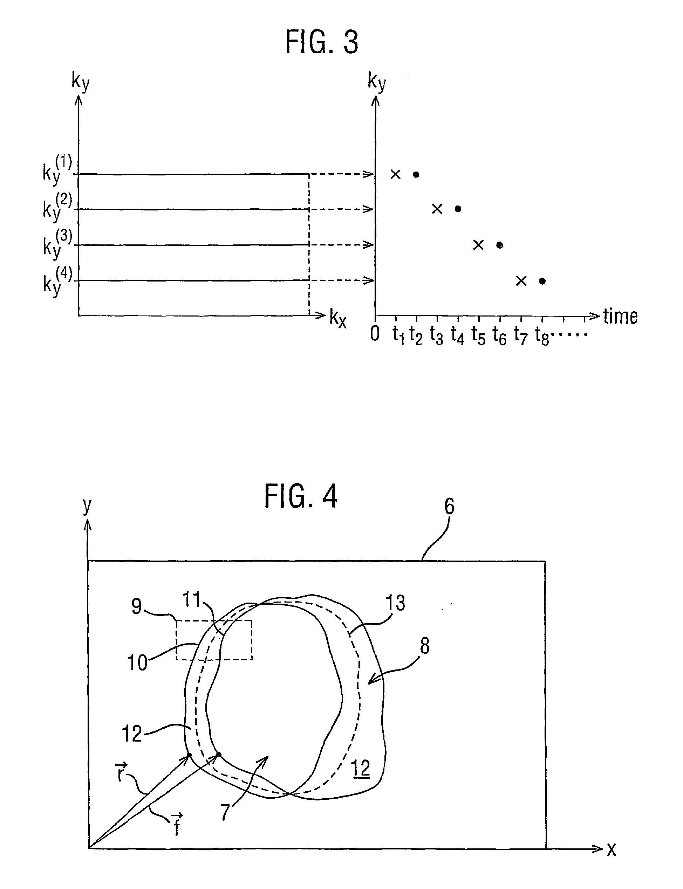

Referring to Figure 3, image data acquisition occurs by collecting NMR signals S(k), where:

$$S(k) = \iiint \rho(x, y, z) \cdot \exp[i(k_x x + k_y y + k_z z)]dxdydz \ ,$$

(i.e. Eq.2 above) in Fourier-space (k-space) representing the spatial frequency components of the image (i.e. $\rho(x,y,z)$) of the imaged slice of the object. The image of the slice is derived from the inverse Fourier transform of the Fourier-space data S(k) acquired for that slice.

The Fourier-space image data items are acquired at successive points within the Fourier-space over a given range of $k_x$-values forming a line (scan line) in the $k_x$-dimension of Fourier-space, representing spatial frequency along the x-dimension in real-space, each line having a different one of several fixed $k_y$-values (e.g. $k_y^{(1)}$, $k_y^{(2)}$, $k_y^{(3)}$... etc).

For example, a scan line (e.g. $k_y^{(1)}$) is selected, then:

(a) first image data items are acquired along the selected scan line with the imaged object in the presence of a gradient field having a gradient value of $+G_x$ in the x-direction. Acquired first image data items are stored in a first memory store; then, once the scanning of the selected scan line ( $k_y^{(1)}$ ) is completed,

(b) the gradient field is inverted to have a value of $-G_x$ in the x-direction (i.e. reversed relative to the its direction in respect of the previous scanning operation). Second image data items are acquired by scanning the same scan line ( $k_y^{(1)}$ ) scanned once more with the imaged object in the presence of the inverted gradient field $-G_x$. Acquired second image data items are stored in a second memory store; then, once the scanning of the selected scan line ( $k_y^{(1)}$ ) is completed,

(c) A new scan line (e.g. $k_y^{(2)}$ ) is then selected, having a different k value in the y-dimension of Fourier-Space slightly displaced from the previous value ( $k_y^{(1)}$ ) , and steps (a) and (b) are repeated until all scan lines have been scanned.

This process of acquiring scan lines, in which the sign of the gradient field is successively reversed alternately in respect of each of the selected scan lines, is repeated a predetermined number of times so as to acquire Fourier-space image data items in a raster-scan fashion during a single continuous image data acquisition time interval. Referring to Figure 3, "forward" scan lines (crosses "x" in Figure 3) in which the gradient field had a gradient value of $+G_x$ in the x-direction, and "reverse" scan lines (dots "•" in Figure 3) in which the gradient field had a gradient value of $-G_x$ in the x-direction (i.e. a reversed direction), are acquired alternately in time such that a reverse and a forward scan is made of each selected scan line before the next selected scan line is scanned. Forward scan lines are scanned at scan periods beginning at times: $t_1$, $t_3$, $t_5$, $t_7$,... etc; while reverse scan lines are scanned at scan times beginning at times: $t_2$, $t_4$, $t_6$, $t_8$,... etc. Thus, forward scanning and reverse scanning of scan lines is interleaved in time.

The image data items $S_f(k)$ acquired in the "forward" scan lines may be labelled as such and stored separately from the image data items $S_r(k)$ acquired in the "reverse" scan lines.

Data acquired in the "forward" scan lines ("x") alone may then be used to generate "forward" images of the object while data acquired in the "reverse" scan lines ("•") alone may be used to generate "reverse" images of the object.

Referring to Figure 4 there is schematically illustrated overlapping real-space images (i.e. $\rho(x,y,z)$) of the imaged slice constructed according to the forward scan lines and the reverse scan lines with the image frames 6 of each coincident. This comparison of the forward and reverse images schematically illustrates the relative displacement of the position of the main feature 8 of the forward image of object relative to the position of the same feature 7 in the reverse image.

The boundary 10 of the main feature 7 in the reverse image is defined by a reverse image boundary vector $\vec{r}$, and the boundary 11 of the main feature 8 in the forward image is defined by a forward image boundary vector $\vec{f}$. The boundary 10 of the main feature in the reverse image is displaced relative to the corresponding boundary 11 in the forward image and so the reverse and forward image boundary vectors differ by an amount defined by the difference vector: $\vec{d} = \vec{f} - \vec{r}$ which represents the relative boundary displacements as between forward and reverse boundary vectors for the image feature of interest. It is to be noted that the aforementioned boundary displacement will typically be more complex than a simple wholesale shift of between otherwise identical forward and reverse boundaries, but may well include distortions/differences in the very shape of the boundary itself. This information will be contained within the difference vector $\vec{d}$.

Furthermore, image sub-features located within the boundary 11 of the forward image feature 8 will typically differ in their position - measured relative to the forward boundary - as compared to the position of the corresponding sub-features in the reverse image - measured relative to the reverse boundary. Thus, in order to correct for image distortions within the boundary of the main feature of interest, a mapping vector is generated as discussed below which maps each pixel of the feature of interest in the forward image onto the corresponding pixel associated with the same image feature in the reverse image. Once each image pixel of interest of the forward image has been paired-off with its corresponding equivalent pixel of interest in the reverse image, via the mapping vector, a third pixel corrected for position and pixel value can be generated as discussed below.

However, initial processing of the forward and reverse image pixels is preferably performed to render the mapping and final correction procedures more efficient and less error prone as follows.

Initially, the boundary of the feature of interest is identified in both the forward and reverse images. Referring to Figure 4, these boundaries are 11 and 10 respectively and are defined according to the boundary vectors $\vec{f}$ and $\vec{r}$ respectively. These boundaries may be identified using methods such as any readily apparent to the skilled person.

Once each boundary is identified and defined, the difference boundary vector $\vec{d} = \vec{f} - \vec{r}$ is determined a third image boundary 13 is then determined according to the forward and reverse boundaries, 11 and 10. The forward and reverse images are then segmented according to the first image boundary 11 and the third image boundary 13 respectively.

In this way a feature of interest (7 or 8) within the image frame of both images may be delineated or segmented from the rest of the image data within both images using the first and third image boundary. Use of these boundaries simplifies subsequent distortion correction of the images.

The forward and reverse images are preferably segmented such that: image pixels outside said first and third image boundary respectively are set to a value of zero; and, image pixels inside the first and third image boundary respectively are retained. This removes noise or irrelevant data from both the first and second image the presence of which can otherwise seriously hamper subsequent image processing of the features of interest within the images.

The gap 12 between a locally "inner" forward (or reverse) image boundary and the locally "outer" reverse (or forward) boundary, where the two boundaries do not coincide, is also reduced when segmentation according to the third image boundary 13 is used. Furthermore, the third image boundary is defined according to either the first or the second image boundary together with an average of the difference between the first image boundary and the second image boundary. By using the average of the difference of the forward and reverse boundaries (11 and 10), one is able to adjust the third image boundary 13 to "smooth" the third image boundary as follows.

The third image boundary is defined by a third image boundary vector $\vec{r}'$ being the sum ($\vec{r}' = \vec{r} + \vec{d}'$) of the reverse boundary vector $\vec{r}$ and an averaged-difference vector $\vec{d}'$ which is a weighted average of the difference vector $\vec{d}$ such that:

$$\vec{d}'_j = \frac{1}{n} \sum_{i=0}^{n} w_i \vec{d}_{j-n/2+i}$$

wherein the $j^{th}$ element $\vec{d}'_j$ of the averaged-difference vector is a weighted average of the $j^{th}$ element, and the n elements neighbouring the $j^{th}$ element, of the difference vector $\vec{d}$ where the weights $w_i$ may be any suitable values including all $w_i$ = 1 (one), in which case the average would be a "Boxcar average" as is well known in the art.

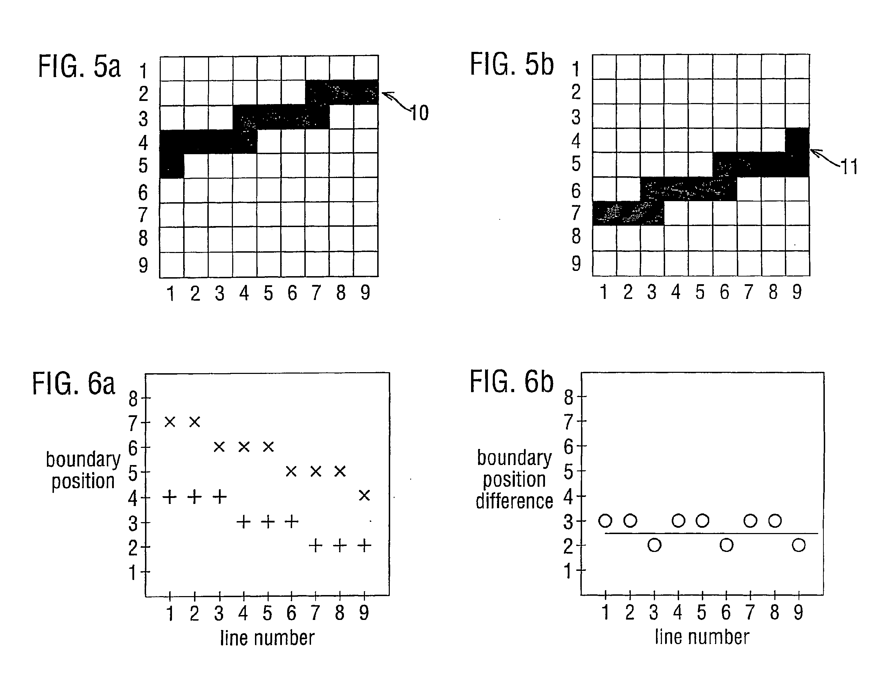

Figures 5a and 5b separately illustrate a small region of the reverse and forward image boundaries, respectively, shown in the inset area 9 of Figure 4. The inset portion 9 of each of the forward and reverse images is illustrated together with image pixel coordinates. As can be seen, due to the raster-scan nature of the image pixels in the forward and reverse images, the boundaries are pixelated and stepped rather than smooth. The forward image boundary 11 is displaced diagonally by three pixels relative to the reverse image boundary 10.

Each Figure 6a illustrates the boundary positions of both the forward (+) and reverse (x) boundaries as a function of line number within the inset region 9. Figure 6b illustrates the value (circles) of the difference vector $\vec{d} = \vec{f} - \vec{r}$ in respect of the forward and reverse boundary vectors within the inset region 9. As can be seen, the value of the difference vector oscillates between the values of 2 and 3 pixel positions due to the stepped nature of the boundaries in question. The averaged-difference vector $\vec{d}'$ is also plotted in Figure 6b (solid horizontal line) to illustrate its smoothing effect upon the difference vector $\vec{d} = \vec{f} - \vec{r}$ and therefore upon the third image boundary $\vec{r}' = \vec{r}' + \vec{d}'$.

Any boundaries of relevant features of interest within any acquired image (I), whether it is within the forward image (If) or within the reverse image (Ir), may initially be identified as follows:

(1) Initially apply a Sobel filtering: Apply a Sobel kernel $G^{Sobel}$ separately in the x-direction ($G_x^{Sobel}$) and the y-direction ($G_y^{Sobel}$) of the image I, where,

$$G_x^{Sobel} = \begin{pmatrix} -1 & 0 & 1 \\ -2 & 0 & 2 \\ -1 & 0 & 1 \end{pmatrix} \quad \text{and} \quad G_y^{Sobel} = \begin{pmatrix} 1 & 2 & 1 \\ 0 & 0 & 0 \\ -1 & -2 & -1 \end{pmatrix}$$

The final Sobel-filtered image $I^{Sobel}$ being obtained from, $I_x^{Sobel} = I \otimes G_x^{Sobel}$ and $I_y^{Sobel} = I \otimes G_y^{Sobel}$ as a magnitude image,

$$I^{Sobel} = \sqrt{(I_x^{Sobel})^2 + (I_y^{Sobel})^2} \; ;$$

(2) then threshold the magnitude image $I^{Sobel}$ at a suitably chosen level "Th", to generate therefrom a threshold image $I^{Th}$ [i, j] such that: $I^{Th}$ [i, j ] =1 if $I^{Sobel}$[i, j] > Th; $I^{Th}$[i, j] = 0 otherwise;

(3) then define "connected regions" each being the group of pixels in which each pixel in the group is immediately next to another pixel in the group, the neighbouring pixel being either above, below, to the left or to the right. Identify the biggest "connected region" being the connected region having the largest number of pixels, and discard all other pixels such that $I^{Th} \rightarrow I^{Biggest}$;

(4) then "close" the image $I^{Biggest}$ by a succession of "dilation" and "erosion" operations:

$$I^{Closed} = (I^{Biggest} \oplus K) \otimes K$$

where the operator $\oplus$ is the dilation operator, and the operator $\otimes$ is a convolution operator. As will be appreciated by the person skilled in the art, if $A \oplus K$ signifies a dilation of image A with structuring element K, the dilation is defined as:

$$C = A \oplus K = \bigcup_{k \in K} (A)_k$$

where $(A)_k$ represents the translation of A by k. Thus, for each non-zero element $k_{i,j}$ of K, the image A is translated by i pixels in the x-direction and by j pixels in the $\gamma$-direction, and summed onto the quantity C using the "OR" operator. Closing of the image may be done using a disk structuring element, such as:

$$K = \begin{pmatrix} 1 & 1 \\ 1 & 1 \end{pmatrix} ;$$

which smoothes contours, fuses narrow breaks and long thin gulfs, eliminates small holes, and fills gaps in contours;

(5) finally, extract the position of the boundary in line j by searching for the pixel position p of the first pixel with a value of 1 (one) in $I^{Closed}$[*,j]. This leads to the forward image boundary vector $\vec{f}$ and the reverse image boundary vector $\vec{r}$ e.g. such that $\vec{f}_j$=p with p being the position of the boundary in the line j of the forward image.

Given a third image boundary, the present invention may include the steps of identifying within that image boundary corresponding/matching pixels of the first image and the second image.

Figure 5 illustrates schematically a preferred method of matching pixel positions in the forward image and the reverse image.

Initially, a first set of pixels is selected from the forward image, in this case a single profile $i_1$ of the image (i.e. one-dimensional scan line of pixels). A second set of pixels is selected from the reverse image, in this case a single profile $i_2$ of the image (i.e. one-dimensional scan line of pixels). The pixels of the forward profile $i_1$ are compared with the pixels of the reverse profile $i_2$ and a measure of similarity between the two profiles is made. This measure may be a correlation measure or a "Mutual Information" (MI) measure. Then, an estimation is made according to the measure of similarity as to whether or not the profiles so compared correspond with the same feature of the imaged object; and if not, the process is repeated in which at least one pixel of forward profile is compared to a pixel of the reverse profile with which it was not compared in the previous comparison.

Accordingly, in each of the forward and reverse profiles, the pixels of the forward profile are repeatedly mapped onto pixels of the same reverse profile, but the nature of the map is iteratively varied to find the optimal map.

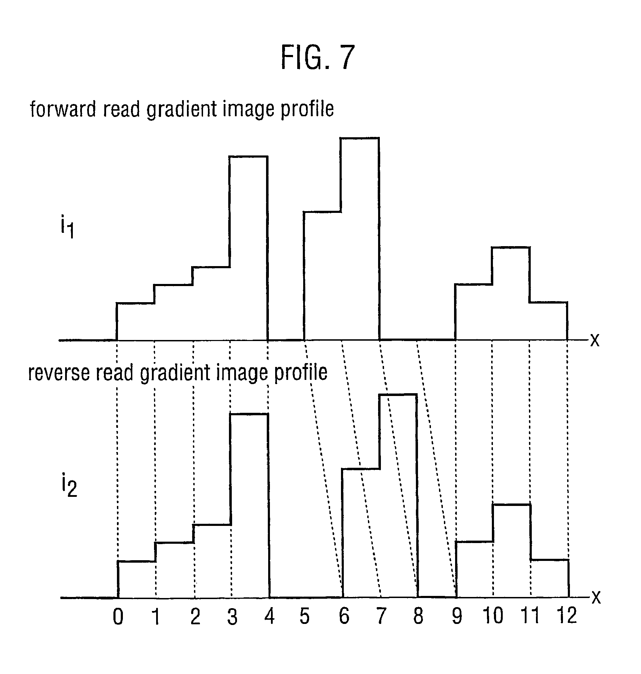

Figure 7 illustrates that the intensities of the majority of the pixels in the forward and reverse profiles illustrated are identical and in the same place, but only a subgroup of pixels (representing the same image sub-feature) in the middle of each profile are relatively displaced. The correct mapping vector relating forward and reverse profiles is:

$$\vec{m} = [0,1,2,3,4,\underline{6,7,8,9},9,10,11,12]$$

where the underlined elements are the displaced pixels of the central sub-feature of the profiles.

The map generation procedure includes collectively shifting only some pixel positions within the forward profile upon successive iterations of the above map-generation procedure. This may occur when it appears that some of the pixels within the profile (e.g. the pixels 0-4 and 9-12 of Figure 7) have been adequately mapped, but others (e.g. subgroup of pixels 5-8) have not. The unmapped subgroup of pixels is then separately shifted iteratively (i.e. the mapping vector changed only in respect of those pixel positions) in order to obtain an improved overall mapping vector.

The mapping vector generation method according to the present example uses an optimisation procedure in which optimal mapping is found if the mapping vector maps the pixels of the forward profile into the pixels of the reverse profile such that the similarity between the mapped forward profile, as compared to the reverse profile, is maximal as follows:

(1) find a starting mapping vector $\vec{m} = \vec{m}_{Start}$ such that every pixel in the forward profile $\vec{i}_1$ maps onto the same pixel position in the reverse profile $\vec{i}_2$ (i.e, set $\vec{m} = i$) ;
(2) assess the quality of the mapping by determining a measure of similarity between the forward profile $\vec{i}_1$ and the reverse profile $\vec{i}_2(\vec{m})$ after mapping transformation (i.e. pixels chosen according to the mapping vector) using either a simple correlation such as:

$$\text{Similarity Measure} = corr(\vec{i}_1, \vec{i}_2(\vec{m}))$$

Or

$$\text{Similarity Measure} = H(\vec{i}_1) + H(\vec{i}_2(\vec{m})) - H(\vec{i}_1, \vec{i}_2(\vec{m}))$$

where the measure of similarity is defined in terms of the entropy $H(\vec{i}_1)$ contained in the forward profile of pixel values, and the entropy $H(\vec{i}_2(\vec{m}))$ contained in the reverse profile of pixel values after applying the mapping. The third term defines the joint entropy of the two profiles. The entropy of a variable X is defined as $H(X) = \sum_x p(x) \log p(x)$ summed over all values of x in the vector X, and p(x) is the probability of a particular value x. The joint entropy of X and Y is $H(X,Y) = \sum_{x,y} p(x,y) \log p(x,y)$ where p (x, y) is the probability of a particular value x in the same position as value y;
(3) modify the mapping vector by exhaustively searching all possible mapping vectors in the proximity of the current mapping vector (alternatively, the modification may be random, or directed in the direction of improved mapping quality, e.g. using a Newton-Raphson optimisation algorithm or the like), return to step (2) to assess the quality of each map until no quality improvement can be achieved.

With reference to Figure 7, the modifications of step (3) include the following mapping vectors for example:

$$\vec{m}_0 = [0,1,2,3,4,6,7,8,9,9,10,11,12,13]$$

$$\vec{m}_{0,+} = [1,2,3,4,6,7,7,8,9,10,11,12,13]$$

$$\vec{m}_{0,-} = [-1,0,1,2,3,4,6,8,9,10,11,12,13]$$

$$\vec{m}_{1,+} = [0,1,2,3,4,6,7,9,10,11,12,13,14]$$

$$\vec{m}_{1,-} = [0,1,2,3,4,6,7,8,8,9,10,11,12]$$

The quality of each is determined before modifying the vector to the next value and determining the quality of the modified vector.

Initially all elements in a first half (or thereabouts) of an initial mapping vector are shifted to the left (i.e. reduced in position value) by one pixel position - the quality of that mapping vector is then determined. Subsequently, all elements in the first half of the given mapping vector are shifted to the right (i.e. increased in position value) by one pixel position - the quality of that mapping vector is then determined. The qualities of the two modified mapping vectors are compared and the one with the better quality is chosen as the first new mapping vector. The process may then be performed using the first new mapping vector but in respect of the other half of that vector (which is identical to the same half of the initial mapping vector) so as to define a second new mapping vector.

Of the aforementioned modified first half of the first new mapping vector, one half (thereabouts) thereof (i.e. one quarter overall) are shifted to the left (i.e. reduced in position value) by one pixel position - the quality of that mapping vector is then determined. Subsequently, all elements in the same one quarter of the given mapping vector are shifted to the right (i.e. increased in position value) by one pixel position - the quality of that mapping vector is then determined. The qualities of the two modified mapping vectors are compared and the one with the better quality is chosen as the third new mapping vector. The process may then be performed using the second new mapping vector but in respect of the other half of that vector (which is identical to the same half of the third new mapping vector).

The process repeats, successively halving the number of pixels being shifted, until no further halving is possible. This represents the optimised mapping vector which maps the position ($x_2$) of each pixel of the forward profile to the position ($x_1$) of the corresponding equivalent pixel in the reverse profile.

Armed with this mapping one may then generate a third image profile from the forward and reverse profiles which is corrected for geometrical image distortions arising from inhomogeneities in the magnetic field of the NMR device as follows:

The position ($x_3$) of an image pixel in the third profile is determined from the positions ($x_1$ and $x_2$) of an image pixel in the reverse and forward profiles respectively via the equation:

$$x_3 = \frac{\alpha x_1 - x_2}{\alpha - 1}$$

where $\alpha$ is the value of said ratio of the values of the gradient field employed in acquiring the respective forward and reverse image data (i.e. $\alpha = -1$)

The pixel intensity values ($i_3$) of each an image pixel at position $x_3$ in the third profile is related to the pixel intensity values ($i_1$, and $i_2$) of an image pixel in the reverse and forward images respectively at positions $x_1$ and $x_2$ via the equation:

$$i_3 = (1-\alpha)\frac{i_1 \cdot i_2}{i_1 - \alpha \cdot i_2} \; .$$

The value $\alpha$ may be other than -1, such that not only is the direction of the gradient field reversed in respect of the forward and reverse images, but its magnitude in the x-direction is also changed.

Further aspects and features of the invention are described below in the following pararaphs:

1. A method of acquiring and processing Magnetic Resonance Image (MRI) data from Nuclear Magnetic Resonance signals generated by an object within a magnetic field having a predetermined spatial gradient, for use in reconstructing an image representing said object, the method comprising the steps of:

acquiring a first set of first image data items using a first value of said predetermined spatial gradient for use in constructing a first image of said object;
acquiring a second set of second image data items using a second value of said predetermined spatial gradient which differs from said first value thereof for use in constructing a second image of said object wherein second image data items of said second set are acquired before acquisition of said first set is complete;
generating third image data items according to first image data items, second image data items and the ratio of said different first and second values of said predetermined spatial gradient.

2. A method according to Paragraph 1 wherein said second image data items of said second set acquired before acquisition of said first set is complete are acquired from points in Fourier-Space which coincide with those points in Fourier-Space from which first image data items of said first set are acquired.

3. A method according to Paragraph 2 in which acquiring said first set of first image data items and said second set of second image data items includes the steps of:

(a) acquiring first image data items from a selected set of points in Fourier-Space; and
(b) acquiring second image data items from said selected set of points in Fourier-Space; and
(c) selecting a new set of points in Fourier-Space and repeating steps (a) and (b) in respect of said new selected set of points until acquisition of said first set is complete.

4. A method according to Paragraph 3 in which said selected set of points in steps (a) and (c) each forms a respective line of points in Fourier-Space wherein a set of points selected in step (c) forms a line of points being substantially parallel to a line of points formed by the selected set of points employed in preceding steps (a) and (b).

5. A method according to any preceding paragraph wherein the ratio of said different values of said predetermined spatial gradient is a constant value.

6. A method according to any preceding paragraph wherein the third image data items include pixel values of an image representing said object and are generated such that the position ($x_3$) of an image pixel in an image constructed according to the third data items is related to the positions ($x_1$ and $x_2$) of an image pixel in an image constructed according to the first and second data items respectively via the equation:

$$x_3 = \frac{\alpha x_1 - x_2}{\alpha - 1}$$

where $\alpha$ is the value of said ratio of said different values of said predetermined spatial gradient.

7. A method according to paragraph 6 wherein pixel intensity values ($i_3$) of an image pixel at position $x_3$ in an image constructed according to the third data items is related to the pixel intensity values ($i_1$ and $i_2$) of an image pixel in an image constructed according to the first and second data items respectively at positions $x_1$ and $x_2$ via the equation:

$$i_3 = (1-\alpha)\frac{i_1 \cdot i_2}{i_1 - \alpha \cdot i_2}$$

where $\alpha$ is the value of said ratio of said different values of said predetermined spatial gradient.

8. A method according to any of Paragraphs 1 to 7 wherein the ratio of said different values of said predetermined spatial gradient is substantially equal to -1 (minus one).

9. A method according to any preceding paragraph including the steps of:

   generating first real-space image data items from said first image data items, and second real-space image data items from said second image data items;
   defining a first image boundary corresponding to the periphery of an image feature within the image frame of an image constructed according to said first real-space image data items;
   defining a second image boundary corresponding to the periphery of said image feature within the image frame of an image constructed according to said second real-space image data items;
   defining a third image boundary according to said first boundary and said second boundary; and,
   segmenting said first real-space image data items according to said first image boundary;
   segmenting said second real-space image data items according to said third image boundary.

10. A method according to Paragraph 9 wherein said first and said second real-space image data items are each segmented such that: data items outside said first and third image boundary are discarded respectively; and, data items inside said first and third image boundary are retained respectively.

11. A method according to Paragraph 9 or Paragraph 10 wherein
the third image boundary is defined according to an average of the difference between the first image boundary and the second image boundary.

12. A method according to Paragraph 11 wherein the third image boundary is defined by one of the first image boundary and the second image boundary modified according to an average of the difference between the first image boundary and the second image boundary.

13. A method according to Paragraph 11 or 12 wherein the first image boundary is defined by a first image boundary vector and the second image boundary is defined by a second image boundary vector and said difference between said first image boundary and said second image boundary is a difference vector being the difference between said first image boundary vector and said second image boundary vector.

14. A method according to Paragraph 13 wherein the third image boundary is defined by a third image boundary vector being one of the first image boundary vector and the second image boundary vector to which is added an averaged-difference vector being an average of said difference vector.

15. A method according to Paragraph 14 wherein the value of each element of said averaged-difference vector is determined as a weighted average of the values of:

   a corresponding element of said difference vector; and,
   a predetermined number of elements of said difference vector which neighbour said corresponding element.

16. A method according to any preceding paragraph including the steps of:

   generating first real-space image data items from said first image data items, and second real-space image data items from said second image data items;

   (a) comparing first real-space data items with second real-space data items;
   (b) estimating whether or not data items so compared correspond with the same feature of the imaged object; and if not,

(c) iteratively repeating steps (a) and (b) in respect of real-space data items at least one of which differs from any of those compared in the previous iteration of step (a).

17. A method according to any preceding paragraph comprising the steps of:

generating first real-space image data items from said first image data items, and second real-space image data items from said second image data items;

(i) selecting a first set of data items from said first real-space image data items;
(ii) selecting a second set of data items from said second real-space image data items;
(iii) comparing data items from said first set with data items from said second set;
(iv) defining a measure of similarity between data items so compared;
(v) estimating according to said measure of similarity whether or not said real-space data items so compared correspond with the same feature of the imaged object; and if not,
(vi) iteratively repeating steps (ii) to (v) in which at least one data item of said first set is compared to a data item of said second set with which it was not compared in the previous iteration of step (iii).

18. A method according to Paragraph 17 wherein said first set and said second set of data items comprises image pixel values corresponding to a group of pixels positioned within an image constructed according to said first and said second real-space image data items respectively whereby the pixel position of each element of the group neighbours the pixel position of another element of the group.

19. A method according to Paragraph 18 in which step (ii) includes selecting a subset of one or more data items from within said second set defining a subgroup of pixel values whereby the pixel position of each element of the subgroup neighbours the pixel position of another element of the subgroup when the subgroup comprises a plurality of elements, and in which step (iii) includes comparing pixel values of the first set with pixel values of the second set in which the pixel position of at least one element of said subset is displaced relative to the pixel position of the same element during the previous iteration of step (iii).

20. A method according to Paragraph 19 in which when the estimation according to step (v) is affirmative steps (ii) to (v) and (vi) are performed in respect only of elements within the subset in respect of which the affirmative estimation according to step (v) was obtained.

21. A method according to Paragraph 19 or 20 wherein each subset comprises a predetermined proportion of the total number of elements from within the set from which they are selected.

22. A method according to Paragraph 21 wherein the predetermined proportion is one half (1/2).

23. A method of reconstructing nuclear Magnetic Resonance images (MRI) or other images using the method of any of preceding Paragraphs 1 to 22.

24. Apparatus for acquiring and processing Magnetic Resonance Image (MRI) data from Nuclear Magnetic Resonance signals generated by an object within a magnetic field having a predetermined spatial gradient, for use in reconstructing an image representing said object, the apparatus comprising:

image acquisition means for acquiring a first set of first image data items using a first value of said predetermined spatial gradient for use in constructing a first image of said object, and for acquiring a second set of second image data items using a second value of said predetermined spatial gradient which differs from said first value thereof for use in constructing a second image of said object, wherein said image acquisition means is arranged to acquire second image data items of said second set before acquisition of said first set is complete;
gradient control means for changing the value of said predetermined spatial gradient;
image processing means for generating third image data items according to first image data items, second image data items and the ratio of said different first and second values of said predetermined spatial gradient.

25. Apparatus according to Paragraph 24 wherein said image data acquisition means is arranged to acquire second image data items of said second set before acquisition of said first set is complete from points in Fourier-Space which coincide with those points in Fourier-Space from which first image data items of said first set are acquired.

26. Apparatus according to Paragraph 25 in which said image data acquisition means is arranged to acquire said first set of first image data items and said second set of second image data items by:

(a) acquiring first image data items from a selected set of points in Fourier-Space; and
(b) acquiring second image data items from said selected set of points in Fourier-Space; and
(c) selecting a new set of points in Fourier-Space and repeating steps (a) and (b) in respect of said new selected set of points until acquisition of said first set is complete.

27. Apparatus according to Paragraph 26 in which said selected set of points in steps (a) and (c) each forms a respective line of points in Fourier-Space wherein a set of points selected in step (c) forms a line of points being substantially parallel to a line of points formed by the selected set of points employed in preceding steps (a) and (b).

28. Apparatus according to any of paragraphs 24 to 27 wherein said gradient control means is arranged to change the value of said predetermined spatial gradient such that the ratio of said different values thereof is a constant value.

29. Apparatus according to any of preceding paragraphs 24 to 28 wherein the third image data items include pixel values of an image representing said object and are generated such that the position ($x_3$) of an image pixel in an image constructed according to the third data items is related to the positions ($x_1$ and $x_2$) of an image pixel in an image constructed according to the first and second data items respectively via the equation:

$$x_3 = \frac{\alpha x_1 - x_2}{\alpha - 1}$$

where $\alpha$ is the value of said ratio of said different values of said predetermined spatial gradient.

30. Apparatus according to paragraph 29 wherein pixel intensity values ($i_3$) of an image pixel at position $x_3$ in an image constructed according to the third data items is related to the pixel intensity values ($i_1$ and $i_2$) of an image pixel in an image constructed according to the first and second data items respectively at positions $x_1$ and $x_2$ via the equation:

$$i_3 = (1-\alpha)\frac{i_1 \cdot i_2}{i_1 - \alpha \cdot i_2}$$

where $\alpha$ is the value of said ratio of said different values of said predetermined spatial gradient.

31. Apparatus according to any of paragraphs 24 to 30 wherein the ratio of said different values of said predetermined spatial gradient is substantially equal to -1 (minus one).

32. Apparatus according to any of preceding paragraphs 24 to 31 wherein said image processing means is arranged to:

generate first real-space image data items from said first image data items, and second real-space image data items from said second image data items;
define a first image boundary corresponding to the periphery of a feature within the image frame of an image constructed according to said first real-space image data items;
define a second image boundary corresponding to the periphery of said feature within the image frame of an image constructed according to said second real-space image data items;
define a third image boundary according to said first boundary and said second boundary;
segment said first real-space image data items according to said first image boundary;
segment said second real-space image data items according to said third image boundary.

33. Apparatus according to paragraph 32 wherein said image processing means is arranged to segment each of said first and said second real-space image data items such that: data items outside said first and third image boundary are discarded respectively; and, data items inside said first and third image boundary are retained respectively.

34. Apparatus according to any of Paragraphs 32 to 33 wherein
the third image boundary is defined according to an average of the difference between the first image boundary and the second image boundary.

35. Apparatus according to Paragraph 34 wherein the third image boundary is defined by one of the first image boundary and the second image boundary modified according to an average of the difference between the first image boundary and the second image boundary.

36. Apparatus according to Paragraph 34 or 35 wherein the first image boundary is defined by a first image boundary vector and the second image boundary is defined by a second image boundary vector and said difference between said first image boundary and said second image boundary is a difference vector being the difference between said first image boundary vector and said second image boundary vector.

37. Apparatus according to Paragraph 36 wherein the third image boundary is defined by a third image boundary vector being one of the first image boundary vector and the second image boundary vector to which is added an averaged-difference vector being an average of said difference vector.

38. Apparatus according to Paragraph 37 wherein the value of each element of said averaged-difference vector is determined as a weighted average of the values of:

a corresponding element of said difference vector; and,
a predetermined number of elements of said difference vector which neighbour said corresponding element.

39. Apparatus according to any of preceding paragraphs 24 to 38 wherein the image processing means is arranged to perform the steps of:

generating first real-space image data items from said first image data items, and second real-space image data items from said second image data items;

(a) comparing first real-space data items with second real-space data items;
(b) estimating whether or not data items so compared correspond with the same feature of the imaged object; and if not,
(c) iteratively repeating steps (a) and (b) in respect of real-space data items at least one of which differs from any of those compared in the previous iteration of step (a).

40. Apparatus according to any of preceding paragraphs 24 to 39 wherein the image processing means is arranged to perform the steps of:

generating first real-space image data items from said first image data items, and second real-space image data items from said second image data items;

(i) selecting a first set of data items from said first real-space image data items;
(ii) selecting a second set of data items from said second real-space image data items;
(iii) comparing data items from said first set with data items from said second set;
(iv) defining a measure of similarity between data items so compared;
(v) estimating according to said measure of similarity whether or not said real-space data items so compared correspond with the same feature of the imaged object; and if not,
(vi) iteratively repeating steps (ii) to (v) in which at least one data item of said first set is compared to a data item of said second set with which it was not compared in the previous iteration of step (iii).

41. Apparatus according to Paragraph 40 wherein said first set and said second set of data items comprises image pixel values corresponding to a group of pixels positioned within an image constructed according to said first and said second real-space image data items respectively whereby the pixel position of each element of the group neighbours the pixel position of another element of the group.

42. Apparatus according to Paragraph 41 in which step (ii) includes selecting a subset of one or more data items from within said second set defining a subgroup of pixel values whereby the pixel position of each element of the subgroup neighbours the pixel position of another element of the subgroup when the subgroup comprises a plurality of elements, and in which step (iii) includes comparing pixel values of the first set with pixel values of the second set in which the pixel position of at least one element of said subset is displaced relative to the pixel position of the same element during the previous iteration of step (iii).

43. Apparatus according to Paragraph 42 in which when the estimation according to step (v) is affirmative steps (ii) to (v) and (vi) are performed in respect only of elements within the subset in respect of which the affirmative estimation according to step (v) was obtained.

44. Apparatus according to Paragraph 42 or 43 wherein each subset comprises a predetermined proportion of the total number of elements from within the set from which they are selected.

45. Apparatus according to Paragraph 44 wherein the predetermined proportion is one half.

46. Apparatus for reconstructing nuclear Magnetic Resonance images (MRI) or other images using the apparatus of any of preceding Paragraphs 24 to 45.

47. A computer system for use in image reconstruction according to the method of any of preceding paragraphs 1 to 23.

48. The use of a computer system for image acquisition and processing according to the method of any of preceding Paragraphs 1 to 23.

49. A program for a computer comprising computer code which when executed on a computer system implements a method of any of preceding paragraph 1 to 23 using acquired image data.

50. A computer program product storing a program for a computer according to Paragraph 49.

51. An image generated using the method of any of paragraphs 1 to 23 or using any of the apparatus of any of paragraphs 24 to 50.

52. A Nuclear Magnetic Resonance Imaging system comprising apparatus according to any of paragraphs 24 to 51.

53. An image generated using the nuclear Magnetic Resonance Imaging system according to Paragraph 52.

54. An image generated using the computer system, or computer program or computer program product according to Paragraph 47, Paragraph 49 or Paragraph 50.

55. A method of image acquisition and processing substantially as described in any one embodiment hereinbefore with reference to the accompanying drawings.

56. Apparatus for image acquisition and processing substantially as described in any one embodiment hereinbefore with reference to the accompanying drawings.

Modifications and variants to the above described embodiments, such as would be readily apparent to the skilled person, are contemplated within the scope of the present invention in any of its aspects.

**Claims**

1. A method of acquiring and processing Magnetic Resonance Image (MRI) data from Nuclear Magnetic Resonance signals generated by an object within a magnetic field including a gradient field having a predetermined spatial gradient, for use in reconstructing an image representing said object, the method comprising the steps of:

   acquiring a first set of first Fourier-space image data items using a first value of said predetermined spatial gradient for use in constructing a first image of said object;

acquiring a second set of second Fourier-space image data items using a second value of said predetermined spatial gradient which differs from said first value thereof for use in constructing a second image of said object wherein second Fourier-space image data items of said second set are acquired before acquisition of said first set is complete;

generating first image pixels from said first Fourier-space image data items, and second image pixels from said second Fourier-space image data items;

(i) selecting a first group of pixels from said first image pixels;

(ii) selecting a second group of pixels from said second image pixels;

(iii) comparing pixels from said first group with pixels from said second group;

(iv) defining a measure of similarity between pixels so compared;

(v) estimating according to said measure of similarity whether or not said pixels so compared correspond with the same feature of the imaged object; and if not,

(vi) iteratively repeating steps (ii) to (v) in which at least one pixel of said first group is compared to a pixel of said second group with which it was not compared in the previous iteration of step (iii), thereby to ascertain which pixels of the first image and the second image are corresponding pixels.

**2.** A method according to Claim 1 including generating third image pixels according to corresponding first image pixels and second image pixels and the ratio of said different first and second values of said predetermined spatial gradient.

**3.** A method according to Claim 1 or Claim 2 wherein said second Fourier-space image data items of said second set acquired before acquisition of said first set is complete are acquired from points in Fourier-Space which coincide with those points in Fourier-Space from which first Fourier-space image data items of said first set are acquired.

**4.** A method according to any preceding claim wherein said first group and said second group of pixels comprises image pixel values corresponding to a group of pixels positioned within an image constructed according to said first and said second image pixels respectively whereby the pixel position of each element of the group neighbours the pixel position of another element of the group.

**5.** A method according to any preceding claim in which step (ii) includes selecting a subset of one or more pixels from within said second group defining a subgroup of pixel values whereby the pixel position of each element of the subgroup neighbours the pixel position of another element of the subgroup when the subgroup comprises a plurality of elements, and in which step (iii) includes comparing pixel values of the first group with pixel values of the second group in which the pixel position of at least one element of said subset is displaced relative to the pixel position of the same element during the previous iteration of step (iii).

**6.** A method according to Claim 5 in which when the estimation according to step (v) is affirmative steps (ii) to (v) and (vi) are performed in respect only of elements within the subset in respect of which the affirmative estimation according to step (v) was obtained.

**7.** A method according to Claim 5 or 6 wherein each subset comprises a predetermined proportion of the total number of elements from within the group from which they are selected.

**8.** A method according to Claim 7 wherein the predetermined proportion is one half (1/2).

**9.** A method according to any preceding claim in which acquiring said first set of first Fourier-space image data items and said second set of second Fourier-space image data items includes the steps of:

(d) acquiring first Fourier-space image data items from a selected set of points in Fourier-Space; and

(e) acquiring second Fourier-space image data items from said selected set of points in Fourier-Space; and

(f) selecting a new set of points in Fourier-Space and repeating steps (a) and (b) in respect of said new selected set of points until acquisition of said first set is complete.

**10.** A method according to Claim 9 in which said selected set of points in steps (a) and (c) each forms a respective line of points in Fourier-Space wherein a set of points selected in step (c) forms a line of points being substantially parallel to a line of points formed by the selected set of points employed in preceding steps (a) and (b).

**11.** A method according to any preceding claim wherein the ratio of said different values of said predetermined spatial gradient is a constant value.

12. A method according to any of preceding claims 2 to 11 wherein the third image pixels include pixel values of an image representing said object and are generated such that the position ($x_3$) of an image pixel in an image constructed according to the third image pixels is related to the positions ($x_1$ and $x_2$) of an image pixel in an image constructed according to the first and second image pixels respectively via the equation:

$$x_3 = \frac{\alpha x_1 - x_2}{\alpha - 1}$$

where $\alpha$ is the value of said ratio of said different values of said predetermined spatial gradient.

13. A method according to claim 12 wherein pixel intensity values ($i_3$) of an image pixel at position $x_3$ in an image constructed according to third image pixels is related to the pixel intensity values ($i_1$ and $i_2$) of an image pixel in an image constructed according to the first and second image pixels respectively at positions $x_1$ and $x_2$ via the equation:

$$i_3 = (1 - \alpha) \frac{i_1 \cdot i_2}{i_1 - \alpha \cdot i_2}$$

where $\alpha$ is the value of said ratio of said different values of said predetermined spatial gradient.

14. A method according to any preceding claim wherein the ratio of said different values of said predetermined spatial gradient is substantially equal to -1 (minus one).

15. A method of reconstructing nuclear Magnetic Resonance images (MRI) using the method of any of preceding Claims 1 to 14.

16. Apparatus for acquiring and processing Magnetic Resonance Image (MRI) data from Nuclear Magnetic Resonance signals generated by an object within a magnetic field including a gradient field having a predetermined spatial gradient, for use in reconstructing an image representing said object, the apparatus comprising:

image acquisition means for acquiring a first set of first Fourier-space image data items using a first value of said predetermined spatial gradient for use in constructing a first image of said object, and for acquiring a second set of second Fourier-space image data items using a second value of said predetermined spatial gradient which differs from said first value thereof for use in constructing a second image of said object, wherein said image acquisition means is arranged to acquire second Fourier-space image data items of said second set before acquisition of said first set is complete;
gradient control means for changing the value of said predetermined spatial gradient;
image processing means arranged to perform the steps of:

generating first image pixels from said first Fourier-space image data items, and second image pixels from said second Fourier-space image data items;

(i) selecting a first group of pixels from said first image pixels;
(ii) selecting a second group of data items from said second image pixels;
(iii) comparing pixels from said first group with pixels from said second group;
(iv) defining a measure of similarity between pixels so compared;
(v) estimating according to said measure of similarity whether or not said pixels so compared correspond with the same feature of the imaged object; and if not,
(vi) iteratively repeating steps (ii) to (v) in which at least one pixel of said first group is compared to a pixel of said second group with which it was not compared in the previous iteration of step (iii), thereby to ascertain which pixels of the first image and the second image are corresponding pixels.

**17.** Apparatus according to Claim 16 wherein said image processing means arranged to generate third pixels according to corresponding first pixels, second pixels and the ratio of said different first and second values of said predetermined spatial gradient.

**18.** Apparatus according to Claim 16 or Claim 17 wherein said first group and said second group of pixels comprises image pixel values corresponding to a group of pixels positioned within an image constructed according to said first and said second image pixels respectively whereby the pixel position of each element of the group neighbours the pixel position of another element of the group.

**19.** Apparatus according to any of Claims 16 to 18 in which step (ii) includes selecting a subset of one or more pixels from within said second group defining a subgroup of pixel values whereby the pixel position of each element of the subgroup neighbours the pixel position of another element of the subgroup when the subgroup comprises a plurality of elements, and in which step (iii) includes comparing pixel values of the first group with pixel values of the second group in which the pixel position of at least one element of said subset is displaced relative to the pixel position of the same element during the previous iteration of step (iii).

**20.** Apparatus according to Claim 19 in which when the estimation according to step (v) is affirmative steps (ii) to (v) and (vi) are performed in respect only of elements within the subset in respect of which the affirmative estimation according to step (v) was obtained.

**21.** Apparatus according to Claim 18 or 19 wherein each subset comprises a predetermined proportion of the total number of elements from within the group from which they are selected.

**22.** Apparatus according to Claim 21 wherein the predetermined proportion is one half.

**23.** Apparatus according to any of Claims 16 to 22 wherein said image data acquisition means is arranged to acquire second Fourier-space image data items of said second set before acquisition of said first set of Fourier-space image data items is complete from points in Fourier-Space which coincide with those points in Fourier-Space from which first Fourier-space image data items of said first set are acquired.

**24.** Apparatus according to Claim 23 in which said image data acquisition means is arranged to acquire said first set of first Fourier-space image data items and said second set of second Fourier-space image data items by:

(d) acquiring first Fourier-space image data items from a selected set of points in Fourier-Space; and
(e) acquiring second Fourier-space image data items from said selected set of points in Fourier-Space; and
(f) selecting a new set of points in Fourier-Space and repeating steps (a) and (b) in respect of said new selected set of points until acquisition of said first set is complete.

**25.** Apparatus according to Claim 24 in which said selected set of points in steps (a) and (c) each forms a respective line of points in Fourier-Space wherein a set of points selected in step (c) forms a line of points being substantially parallel to a line of points formed by the selected set of points employed in preceding steps (a) and (b).

**26.** Apparatus according to any of claims 16 to 25 wherein said gradient control means is arranged to change the value of said predetermined spatial gradient such that the ratio of said different values thereof is a constant value.

**27.** Apparatus according to any of preceding claims 16 to 26 wherein the third image pixels include pixel values of an image representing said object and are generated such that the position ($x_3$) of an image pixel in an image constructed according to the third image pixels is related to the positions ($x_1$ and $x_2$) of an image pixel in an image constructed according to the first and second image pixels respectively via the equation:

$$x_3 = \frac{\alpha x_1 - x_2}{\alpha - 1}$$

where $\alpha$ is the value of said ratio of said different values of said predetermined spatial gradient.

**28.** Apparatus according to claim 27 wherein pixel intensity values ($i_3$) of an image pixel at position $x_3$ in an image

constructed according to the third image pixels is related to the pixel intensity values ($i_1$ and $i_2$) of an image pixel in an image constructed according to the first and second image pixels respectively at positions $x_1$ and $x_2$ via the equation:

$$i_3 = (1-\alpha)\frac{i_1 \cdot i_2}{i_1 - \alpha \cdot i_2}$$

where $\alpha$ is the value of said ratio of said different values of said predetermined spatial gradient.

29. Apparatus according to any of claims 16 to 28 wherein the ratio of said different values of said predetermined spatial gradient is substantially equal to -1 (minus one).

30. Apparatus for reconstructing nuclear Magnetic Resonance images (MRI) or other images using the apparatus of any of preceding Claims 16 to 29.

31. The use of a computer system for image acquisition and processing according to the method of any of preceding Claims 1 to 15.

32. A program for a computer comprising computer code which when executed on a computer system implements a method of any of preceding claim 1 to 15 using acquired image data.

33. A computer program product storing a program for a computer according to Claim 32.

34. A Nuclear Magnetic Resonance Imaging system comprising apparatus according to any of claims 16 to 33.

FIG. 1

FIG. 2

# FIG. 3

# FIG. 4

FIG. 5a

FIG. 5b

FIG. 6a

FIG. 6b

# FIG. 7

forward read gradient image profile

$i_1$

reverse read gradient image profile

$i_2$

0  1  2  3  4  5  6  7  8  9  10  11  12

**European Patent Office**

## EUROPEAN SEARCH REPORT

Application Number

EP 08 00 3252

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| P,X | REINSBERG SA ET AL: "Mutual information-based correction of B0 inhomogeneity, susceptibility- and chemical-shift artefacts" PROCEEDINGS OF THE INTERNATIONAL SOCIETY FOR MAGNETIC RESONANCE IN MEDICINE, 11TH SCIENTIFIC MEETING AND EXHIBITION, TORONTO, CANADA, 10-16 JULY 2003, 10 July 2003 (2003-07-10), page 1049, XP002479792 * the whole document * | 1-34 | INV. G01R33/565 |
| A | DONG S ET AL: "Rectification of distortion in MRI for stereotaxy" PROCEEDINGS OF THE ANNUAL SYMPOSIUM ON COMPUTER BASED MEDICAL SYSTEMS. DURHAM, JUNE 14 - 17, 1992, NEW YORK, IEEE.D, US, vol. SYMP. 5, 14 June 1992 (1992-06-14), pages 181-189, XP010028189 ISBN: 0-8186-2742-5 Sections "MRI Distortion and Rectification", "Experiments" | 1-34 | |
| A | US 5 099 208 A (FITZPATRICK J M ET AL) 24 March 1992 (1992-03-24) * column 6, line 1 - column 8, line 52 * * column 10, lines 5-28 * * figure 1A * | 1-34 | TECHNICAL FIELDS SEARCHED (IPC) G01R G01N G01V |
| A | HAACKE EM ET AL: "Magnetic resonance imaging - Physical principles and sequence design" 1999, JOHN WILEY & SONS, INC. , NEW YORK , XP002287202 ISBN: 0471351288 * page 803 - page 804; figure 26.17 * | 1-34 | |

-/--

The present search report has been drawn up for all claims

| Place of search | Date of completion of the search | Examiner |
|---|---|---|
| Munich | 9 May 2008 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 1 942 350 A1

**European Patent Office**

## EUROPEAN SEARCH REPORT

Application Number

EP 08 00 3252

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| P,A | WEISKOPF N ET AL: "Correction of geometric distortion in fMRI: A single-shot technique using multi-echo echo-planar imaging (EPI)" PROCEEDINGS OF THE INTERNATIONAL SOCIETY FOR MAGNETIC RESONANCE IN MEDICINE, 11TH SCIENTIFIC MEETING AND EXHIBITION, TORONTO, CANADA, 10-16 JULY 2003, 10 July 2003 (2003-07-10), page 1742, XP002287244 * the whole document * | 1-34 | |
| T | STEFAN A REINSBERG ET AL: "A complete distortion correction for MR images: II. Rectification of static-field inhomogeneities by similarity-based profile mapping; B0 correction of MR images" PHYSICS IN MEDICINE AND BIOLOGY, TAYLOR AND FRANCIS LTD. LONDON, GB, vol. 50, no. 11, 7 June 2005 (2005-06-07), pages 2651-2661, XP020084220 ISSN: 0031-9155 * the whole document * | 1-34 | |
| T | SIMON J DORAN ET AL: "A complete distortion correction for MR images: I. Gradient warp correction; Gradient warp correction of MR images" PHYSICS IN MEDICINE AND BIOLOGY, TAYLOR AND FRANCIS LTD. LONDON, GB, vol. 50, no. 7, 7 April 2005 (2005-04-07), pages 1343-1361, XP020084555 ISSN: 0031-9155 * the whole document * | 1-34 | TECHNICAL FIELDS SEARCHED (IPC) |

The present search report has been drawn up for all claims

| Place of search | Date of completion of the search | Examiner |
|---|---|---|
| Munich | 9 May 2008 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 00 3252

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2008

| Patent document cited in search report | Publication date | Patent family member(s) | Publication date |
|---|---|---|---|
| US 5099208 A | 24-03-1992 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **HSUAN CHANG ; J. MICHAEL FITZPATRICK.** A Technique for Accurate Magnetic Resonance Imaging in the Presence of Field Inhomogeneities. *IEEE Transactions on Medical Imaging,* September 1992, vol. 11 (3), 319